# EUROPÄISCHE PATENTANMELDUNG

(11) **EP 4 610 604 A1**
(43) Veröffentlichungstag der Anmeldung: **03.09.2025**
(21) Anmeldenummer: 24160319.0
(22) Anmeldetag: 28.02.2024
(51) Int. Cl.: G01H 1/00, G01N 29/12, G01R 31/303, B06B 1/06

(54) **VERFAHREN SOWIE SYSTEM ZUR ÜBERPRÜFUNG DES BETRIEBSZUSTANDES EINES LEISTUNGSHALBLEITER-MODULS**

(71) Anmelder: Siemens Aktiengesellschaft, 80333 München (DE)
(72) Erfinder: Bickel, Heinz Dietrich Philipp, 81677 München (DE); Kriegel, Kai, 81739 München (DE); Mitic, Gerhard, 81827 München (DE); Stegmeier, Stefan, 81825 München (DE); Walbrecker-Baar, Christian, 85757 Karlsfeld (DE)
(74) Vertreter: Siemens Patent Attorneys

(57) **Zusammenfassung**

Die vorliegende Erfindung betrifft ein Verfahren zur Überprüfung des Betriebszustandes eines Leistungshalbleiter-Moduls sowie ein System aufweisend ein Leistungshalbleiter-Modul.

## Beschreibung

Die vorliegende Erfindung betrifft ein Verfahren zur Überprüfung des Betriebszustandes eines Leistungshalbleiter-Moduls sowie ein System aufweisend ein Leistungshalbleiter-Modul.

Leistungshalbleiter-Module weisen eine hohe, aber begrenzte Lebensdauer auf, welche im Wesentlichen aus der thermischen Belastung im Betrieb und insbesondere aus großen Temperaturschwankungen resultiert. Aufgrund der unterschiedlichen Ausdehnungskoeffizienten der Aufbaumaterialien der Module entstehen im Bereich der Verbindungen der unterschiedlichen Materialien thermisch induzierte mechanische Spannungen, welche schließlich zu Rissen, Delaminationen oder Fehlstellen führen. Die häufigsten Ausfallursachen für Leistungshalbleiter-Module bilden dabei die Bonddrähte und Lotschichten. Typische Fehlermechanismen sind der Bond Lift-Off, das heißt das Abheben bis hin zum Riss des Bonddrahtes, der Heel-Crack oder die Lotermüdung von Chip- und Systemlot, welches das unterliegende Lot des Keramikträgers umfasst.

Im Rahmen der Modul-Entwicklung haben sich in der Praxis zur Abgabe einer LebensdauerPrognose beschleunigte Alterungstests etabliert. Zu diesen Tests gehören beispielsweise Lastzyklen-Tests oder die direkte Durchführung von Temperaturzyklen. Hierbei wird in standardisierten Versuchsaufbauten eine bestimmte Zyklenzahl vorgegeben, welche ein Modul ohne Verlust der eigentlichen Funktionalität durchlaufen können muss. Über einen Temperaturfühler am Modul und mathematische Wahrscheinlichkeitsverteilungen lässt sich dann ein ungefährer Alterungsgrad voraussagen. Der eigentliche Nachweis der tatsächlichen Alterung kann nach den Alterungstests beispielsweise durch ein Öffnen des Moduls und einem Schliff erfolgen. Weiterhin lässt sich der Alterungsgrad von Leistungshalbleiter-Modulen durch diverse Verfahren auch ortsaufgelöst bestimmen. Zu diesen Verfahren zählen beispielsweise das Röntgen, die Ultraschallmikroskopie oder die Thermographie. Diese bildgebenden Verfahren ermöglichen eine Detektion der erwähnten Alterungserscheinungen, jedoch sind diese sehr aufwändig und in den seltensten Fällen in der Anwendungsumgebung des Moduls durchführbar.

Vor diesem Hintergrund des Standes der Technik ist es daher Aufgabe der Erfindung, ein verbessertes Verfahren zur Überprüfung des Betriebszustandes eines Halbleiter-Bauteils in einer elektronischen Baugruppe sowie ein System zur Ausführung dieses verbesserten Verfahrens zu schaffen. Insbesondere soll mit dem erfindungsgemäßen Verfahren eine einfache, kostengünstige und zuverlässige Überprüfung der mechanischen Integrität des Aufbaus und der Anbindung eines Halbleiter-Bauteils in einem Leistungshalbleiter-Modul in der Betriebsumgebung und unter Betriebsbedingungen ermöglicht werden.

Diese Aufgabe der Erfindung wird mit einem Verfahren mit den im Anspruch 1 angegebenen Merkmalen sowie mit einem System mit den in Anspruch 10 angegebenen Merkmalen gelöst.

Bevorzugte Weiterbildungen der Erfindung sind in den zugehörigen Unteransprüchen, der nachfolgenden Beschreibung und der Zeichnung angegeben.

Das erfindungsgemäße Verfahren ist ein Verfahren zur Überprüfung des Betriebszustandes eines Leistungshalbleiter-Moduls mindestens umfassend ein flächig ausgestaltetes piezoelektrisches Substrat mit mehreren metallischen Kontaktierungsstellen auf der Ober- und Unterseite des Substrats, wobei auf einer der metallischen Kontaktierungsstellen an der Oberseite ein Leistungshalbleiter und auf dem piezoelektrischen Substrat ein Schwingungs-Sensor angeordnet ist. Das Verfahren umfasst die Schritte:
a) Aussenden mechanischer Schwingungen durch elektrische Anregung zumindest eines Teilbereiches des piezoelektrischen Substrats;
b) Ermitteln der Schwingungs-Werte der Schwingungen des Substrats durch den Schwingungs-Sensor;
c) Vergleich der im Verfahrensschritt b) gemessenen Schwingungs-Werte mit einem oder mehreren Schwingungs-Referenzwerten, wobei die Schwingungs-Referenzwerte an einem Leistungshalbleiter-Modul mit bekannten Betriebszustand erhoben wurden;
d) Ausgeben einer Mitteilung und/oder Ablegen des im Verfahrensschritt c) ermittelten Vergleichsergebnisses in einem elektronischen Speicher.

Überraschenderweise wurde gefunden, dass durch die Bestimmung der Schwingungseigenschaften des Substrats Aussagen über mechanische Integrität des Aufbaus des Leistungshalbleiter erhalten werden können, welche im hohen Maße mit dem Alterungsgrad des Leistungsmoduls korrelieren. Die Messung liefert charakteristische, quantitative Größen und ist in einem hohen Maße reproduzierbar. Die Schwingungseigenschaften des Substrats sind dabei nicht nur über die Eigenschaften des Substrats selbst festgelegt. In die Schwingungseigenschaften gehen auch die mechanischen Anbindungen der weiteren funktionalen Bestandteile des Moduls mit ein. Auch diese Anbindungen verändern die gemessenen Schwingungseigenschaften, sodass auch die Anbindungsumgebung des Substrats über dieses Verfahren erfasst wird. Lotbrüche, eine Ablösung des Bonddrahtes oder Änderungen in den mechanischen Eigenschaften eines schützenden, polymeren Überzugs, welcher die einzelnen Bauteile zumindest an der Oberfläche kontaktiert, führen zu einer Änderung der mechanischen Kopplung der Einzelteile und wirken sich auf die Schwingungseigenschaften des Substrats aus. Somit ist Alterung des gesamten Moduls über die Bestimmung im laufenden Betrieb erfass- und quantifizierbar. Aus der Messung ergeben sich ein oder mehrere integrale Schwingungsparameter des mechanischen Aufbaus, welche sowohl proportional zur mechanischen oder chemischen Belastung des Moduls sind. Korrosion durch eindringende Fremdstoffe und häufige thermische Lastzyklen können somit dem Grunde nach über das Schwingungsverhalten erfasst werden. Neben einer aktuellen Bestimmung des Zustandes des Moduls können die Schwingungseigenschaften als Grundlage in eine Restlebensdauerprognose für das Modul einfließen oder verwendet werden, da die Restlebensdauer im hohen Maße mit der mechanischen Integrität des Aufbaus verknüpft ist.

Das erfindungsgemäße Verfahren ist ein Verfahren zur Überprüfung des Betriebszustandes eines Leistungshalbleiter-Moduls. Leistungshalbleiter-Module sind Bauelemente der Leistungselektronik, wie beispielsweise bipolare Leistungstransistoren, wie Schaltnetzteile und DC/DC-Wandler, Leistungs-MOSFET, IGBTs, Motorsteuerungen und Umrichter, außerdem Thyristoren, insbesondere Stromrichter, Halbleiterrelais, Impulsstromquellen, Ansteuerungen von Thyristoren, oder GTO-Thyristoren. Das Verfahren zur Überprüfung des Betriebszustandes beinhaltet zumindest die quantitative Erfassung und Auswertung eines mechanischen Schwingungs-Parameters, welcher Aussagen über die Eignung des Moduls zur weiteren Erfüllung der Modulaufgaben ermöglicht. Der Betriebszustand kann beispielsweise dahingehend qualifiziert werden, dass das Modul im Rahmen üblicher Parameter funktioniert. Die Erhebung des oder der Parameter kann aber auch ergeben, dass der quantitativ erhaltene Wert außerhalb eines festgelegten Bereiches liegt und somit eine Fehlfunktion oder ein baldiges Versagen des Moduls nicht ausgeschlossen werden kann. Insofern kann die Überprüfung des Betriebszustandes ergeben, das ist Modul sofort oder aber innerhalb einer festgelegten oder berechneten Zeitspanne ausgetauscht werden soll. Das Verfahren ermöglicht somit eine verlässlichere, nicht-destruktive, im Bauteilbetrieb durchführbare Detektion alterungsbedingter Schäden oder Delaminationen an leistungselektronischen Baugruppen sowie an einzelnen Bauteilen dieser Baugruppen, insbesondere für Leistungsmodule in leistungselektronischen Geräten.

Das Leistungshalbleiter-Modul umfasst mindestens ein flächig ausgestaltetes piezoelektrisches Substrat mit mehreren metallischen Kontaktierungsstellen auf der Ober- und Unterseite des Substrats. Die elektronischen Komponenten des Leistungshalbleiter-Moduls sind auf einem Substrat fixiert, welches den mechanischen Zusammenhalt der einzelnen Komponenten gewährleistet. Das Substrat kann ein übliches in Leistungshalbleitern verwendetes Substrat sein, wobei der Begriff flächig ausgestaltet angibt, dass die Grundform des Substrats einer Platte oder Schicht entspricht, deren Dicke kleiner ist als die Ausdehnung in der Breite und Länge. Als Substrat wird in diesen Fällen nur das Trägermaterial, beispielsweise in Form eines Keramikträgers, bezeichnet. Das Substrat mit weiteren Bestandteilen, wie beispielsweise die Leitungsbahnen, kann dann als DCB-Substrat bezeichnet werden. Das Substratmaterial ist piezoelektrisch. Somit ist das Substratmaterial geeignet, über eine Änderung der elektrischen Polarisation elastisch verformt zu werden. Insbesondere kann das Substrat durch Anlegen einer elektrischen Spannung verformt werden. Das Substrat trägt auf mindestens zwei Seiten metallische Kontaktierungsstellen, wobei die Seite, auf welcher der Leistungshalbleiter-Chip angeordnet ist, als Oberseite des Substrats und die dieser Seite entgegengesetzte Oberfläche, als Unterseite des Substrats definiert ist. Die metallischen Kontaktierungsstellen können in Form von Leitungsbahnen, beispielsweise aus Kupfer, auf dem Substrat vorliegen. Die metallischen Kontaktierungsstellen stellen die elektrischen Kontaktierungen zwischen den einzelnen Bauteilen des Moduls her.

Auf einer der metallischen Kontaktierungsstellen an der Oberseite des Substrats ist ein Leistungshalbleiter angeordnet. Die Kontaktierung des Leistungshalbleiters mit der metallischen Kontaktierungsstellen kann beispielsweise über eine Lotverbindung erfolgen. Es ergibt sich eine direkte mechanische und elektrische Anbindung des Leistungshalbleiters über das Lot an die metallische Kontaktierungsstelle mit dem Substrat.

Auf dem piezoelektrischen Substrat des Leistungshalbleiter-Moduls ist ein Schwingungs-Sensor angeordnet. Im mechanischen Kontakt mit dem piezoelektrischen Substrat ist erfindungsgemäß ein Sensor angebracht, welcher in der Lage ist, die Auslenkung des Substrats in mindestens einer Raumrichtung als Funktion der Zeit zu detektieren. Als prinzipielle Größen kann der Sensor dabei beispielsweise die Höhe der Substratauslenkung, die Anzahl an Substratauslenkungen pro Zeiteinheit oder eine Phasenverschiebung zwischen auftretenden Schwingungsamplituden und Anregungsamplituden erfassen.

Das Verfahren umfasst den Verfahrensschritt a), das Aussenden mechanischer Schwingungen durch elektrische Anregung zumindest eines Teilbereiches des piezoelektrischen Substrats. Zur Erzeugung einer mechanischen Auslenkung des Substrats wird dieses über das Anlegen einer elektrischen Spannung in Schwingungen versetzt. Aufgrund der piezoelektrischen Eigenschaften des Substrats führt die angelegte elektrische Spannung zu einer Änderung der elektrischen Polarisation des Substratmaterials und somit zu einer reversiblen Expansion und Kontraktion des Substrats. Die elektrische Anregung kann dabei das gesamte Substrat betreffen oder auf einen Teilbereich des Substrats beschränkt sein. Der ausgewählte Teilbereich des Substrats kann über die Anbringung der elektrischen Kontakte zur elektrischen Anregung des Substrats örtlich eingeschränkt werden. Die elektrischen Kontakte können auf einer oder unterschiedlichen Oberflächenseiten des Substrats angeordnet sein. Es ist auch möglich, dass die elektrischen Kontakte an einem Seitenbereich des Substrats angeordnet sind.

Das Verfahren umfasst den Verfahrensschritt b), das Ermitteln der Schwingungs-Werte von Schwingungen des Substrats durch den Schwingungs-Sensor. Über dem am Substrat angeordneten Schwingungs-Sensor werden physikalische Parameter, wie beispielsweise die Höhe der mechanischen Auslenkung des Substrats und die Anzahl der Substratauslenkungen pro Zeiteinheit, als Schwingungs-Werte erfasst. Die Werte können kontinuierlich, in festgelegten Zeitabständen oder punktuell für eine gewisse Zeitspanne erfasst werden. Der Schwingungs-Sensor erfasst dabei die Schwingungseigenschaften des Substrats und der am Substrat angeordneten und mechanisch mit diesen verbundenen Bestandteilen.

Das Verfahren umfasst den Verfahrensschritt c), den Vergleich der im Verfahrensschritt b) gemessenen Schwingungs-Werte mit einem oder mehreren Schwingungs-Referenzwerten, wobei die Schwingungs-Referenzwerte an einem Leistungshalbleiter-Modul mit bekannten Betriebszustand erhoben wurden. Der Referenzwert kann beispielsweise der gemessene Wert an einem neuen, d.h. nicht gealterten Modul sein. Es ist auch möglich, dass der Referenzwert einen Mittelwert der letzten Messungen am Modul darstellt. Alternativ kann der Referenzwert rein rechnerisch aus der bekannten Geometrie des Moduls berechnet werden. Ein weiteres Modell kann beinhalten, das für eine Mehrzahl an Modulen ein natürlicher Alterungsprozess unter Betriebsbedingungen nachgestellt wird. Die Referenzwerte als Funktion der Betriebsdauer ergeben sich dann als Mittelwerte der gemessenen Schwingungs-Eigenschaften der Substrate der betrachteten Module. Bei dem Referenzwert kann es sich auch um einen Referenzbereich handeln. Der Referenzbereich kann beispielsweise die Standardabweichung der Mittelwerte im letzten Modell als Bereichsgrenzen umfassen. Der Vergleich der beiden Werte, aktuell gemessen gegen Referenz, kann beispielsweise eine Subtraktion des gemessenen Wertes vom Referenzwert umfassen. Als Funktion der resultierenden Differenz aus gemessenen und Referenzwert kann auf einen vergleichbaren, besseren oder schlechteren Zustand des Moduls im Vergleich zur gewählten Referenz geschlossen werden. Der Vergleich kann eine Temperaturkompensation oder -korrektur der aktuell gemessenen Werte beinhalten.

Das Verfahren umfasst den Verfahrensschritt d), das Ausgeben einer Mitteilung und/oder Ablegen des im Verfahrensschritt c) ermittelten Vergleichsergebnisses in einem elektronischen Speicher. Der Vergleich der gemessenen Größe mit dem hinterlegten Referenzwert kann innerhalb dieses Verfahrensschrittes entweder in einem Speicher abgelegt werden, welcher nach dem Ablegen die Vergleichsergebnisse, beispielsweise als Funktion der Zeit, aufweist. Es ist aber auch möglich, dass eine Mitteilung in Form eines akustischen oder eines optischen Signals ausgegeben wird. Beispielsweise kann dies in Form einer Leuchtdiode erfolgen, welche bei einem Zustand innerhalb eines vorgegebenen Referenzwertebereiches "grün" und bei einem Zustand des Moduls mit Schwingungs-Eigenschaften des Substrats außerhalb des vorgegebenen Referenzwertes "rot" anzeigt. Das Ablegen des Vergleichsergebnisses in einem elektronischen Speicher kann beispielsweise noch weitere Schritte umfassen. Die weiteren Schritte können beispielsweise darin bestehen, dass die Differenz zu vorherigen Werten bestimmt und daraus ein Trend berechnet wird. Insofern können aus mehreren, aufgenommenen Datenpunkten oder Vergleichsergebnissen Trendgrößen bestimmt werden. Dies kann die Aussagefähigkeit bezüglich zeitlicher Veränderungen im Modul und die Statistik des Verfahrens verbessern.

In einer bevorzugten Ausführungsform des Verfahrens kann die elektrische Anregung des piezoelektrischen Substrats im Verfahrensschritt a) durch Anlegen einer Spannung zwischen einer metallischen Kontaktierungsstelle auf der Oberseite des Substrats und auf einer dieser Seite entgegengesetzten Unterseite des Substrats erfolgen. Um möglichst verlässliche Werte für die mechanische Auslenkung des Substrats zu erhalten, hat sich als besonders vorteilhaft herausgestellt, dass die elektrische Anregung des Substrats über die gesamte Dicke des Substrats hinweg erfolgt. Somit wird der gesamte Substratquerschnitt zur piezoelektrischen Erzeugung einer Auslenkung genutzt. Eine metallische Kontaktierungsstelle auf der Oberseite kann in Form einer Leiterbahn aus Kupfer ausgestaltet sein. Die an der Unterseite des Substrats erforderliche Kontaktierungsstelle zur Ausbildung der elektrischen Anregung kann eine zusätzliche elektrische Kontaktierungsstelle sein, welche nicht durch einen Standardaufbau von Leistungshalbleiter-Modulen bedingt ist. Es ist aber auch möglich, dass die untere metallische Kontaktierungsstelle sich ebenfalls aus einem Standardaufbau von Leistungshalbleiter-Modulen ergibt. Diese Standardstelle weist dann beispielsweise eine zusätzliche elektrische Leitungsbahn auf, welche in Kombination mit der metallischen Kontaktierungsstelle auf der Oberseite des Substrats eine piezoelektrische Spannungs-Anregung des Substrats über das Substrat hinweg ermöglicht.

In einer weiter bevorzugten Ausführungsform des Verfahrens kann die elektrische Anregung des piezoelektrischen Substrats im Verfahrensschritt a) durch Anlegen einer Spannung an mindestes der metallischen Kontaktierungsstelle erfolgen, auf welcher der Leistungshalbleiter angeordnet ist. Zum Erhalt möglichst spezifischer Informationen über die Umgebung des Leitungshalbleiter-Chips hat sich als besonders günstig herausgestellt, dass die elektrische Anregung des piezoelektrischen Substrats unmittelbar an der Stelle erfolgt, an der der Leistungshalbleiter mittelbar an dem Substrat angeordnet ist. Durch die hohe thermische Belastung dieser Anbindungsstelle können Änderungen im mechanischen Aufbau insbesondere an dieser Stelle stattfinden. Die Anregung zum Schwingen des Substrats an dieser Stelle kann somit spezifischere Schwingungs-Werte liefern, welche signifikantere Aussagen über das Alterungsverhalten des Moduls erlauben.

In einem bevorzugten Aspekt des Verfahrens können die Schwingungs-Werte im Verfahrensschritt b) durch einen MEMS- (mikro-elektro-mechanisches System) oder durch einen SAW- (Surface acoustic wave) Sensor gemessen werden. Aufgrund ihrer Robustheit und thermischen Stabilität haben sich Schwingungs-Sensoren mit oben genannten Grundaufbauten oder aus oben genannten Klassen als besonders geeignet herausgestellt. Die Sensoren weisen eine hinreichende Sensitivität auch unter hohen Temperaturbelastungen sowie eine geringe Masse und Größe auf. Letzteres ist insbesondere günstig, um eine möglichst spezifische Aussage über die Alterungseigenschaften und die mechanische Integrität des Moduls zu erhalten.

In einer bevorzugten Charakteristik des Verfahrens kann der Schwingungs-Sensor mindestens die Frequenz und/oder Amplitude von Schwingungen des Substrats erfassen. Zur besonders aussagekräftigen Überwachung des Betriebszustandes des Moduls hat sich die Erfassung der Frequenz oder der Amplitude der Substratschwingungen als besonders geeignet herausgestellt. Diese beiden Größen ändern sich in signifikanter Weise als Funktion der Alterung des Moduls und insbesondere im Falle von Brüchen oder Delaminierungen einzelner Modulbestandteile. Besonders kann sich ein kombinierter Parameter aus der Frequenz und der Amplitude der Schwingungen zur Überwachung der Modulalterung eignen.

In einer bevorzugten Ausführungsform des Verfahrens kann das piezoelektrische Substrat aus AIN und die metallischen Kontaktierungsstellen aus Kupfer bestehen. Aluminiumnitrit-Substrate haben sich in Kombination mit metallischen Kontaktierungsstellen aus Kupfer im Rahmen dieses Verfahrens als besonders geeignet herausgestellt. Das Aluminiumnitrit stellt über weite Temperaturbereiche einen ausreichend hohen piezoelektrischen Effekt bereit. Somit können in dieser Konstellation Änderungen im mechanischen Aufbau des Moduls besonders verlässlich nachgewiesen werden.

In einer weiterhin bevorzugten Ausführungsform des Verfahrens kann der Vergleich im Verfahrensschritt c) unter Berücksichtigung der aktuellen Temperatur des Leistungshalbleiter-Moduls erfolgen. Neben den Änderungen am mechanischen Gefüge des Moduls kann auch die aktuelle Modultemperatur zu Änderungen im Substrat-Schwingungsverhalten beitragen. Aufgrund dieses Zusammenhangs hat es sich als sehr günstig herausgestellt, dass die aktuell gemessenen Schwingungs-Werte in einer temperaturkompensierten Form betrachtet und abgelegt werden. Diese Berücksichtigung der Temperaturabhängigkeit des Schwingungsverhalten des Substrats kann zu einer verlässlicheren Beurteilung des Alterungszustandes des Moduls führen.

In einer bevorzugten Charakteristik des Verfahrens kann das Ermitteln der Schwingungs-Werte im Verfahrensschritt b) unter Verwendung eines elektronischen Frequenzfilters erfolgt. Neben einer Kompensation der aktuellen Betriebstemperatur des Moduls kann weiterhin die Robustheit der Methode durch Ausschluss bestimmter Schwingungswerte von der weiteren Beurteilung erhöht werden. Dieser Ausschluss bestimmter Schwingungswerte von der weiteren Evaluierung kann über die Verwendung eines elektronischen Frequenzfilters erfolgen, welcher beispielsweise in der Messelektronik des Sensors integriert, vorliegen kann. Es ist aber auch möglich, dass der elektronische Frequenzfilter digital im Rahmen der Auswerteroutine angewendet wird. Über die Filterfunktion können Fehlmessungen oder nicht signifikante Frequenz- oder Amplitudenbereiche von einem weiteren Vergleich mit Referenzwerten ausgeschlossen werden.

Des Weiteren erfindungsgemäß ist die Verwendung des erfindungsgemäßen Verfahrens zur Bestimmung der mechanischen Integrität eines Leistungshalbleiter-Moduls. Das erfindungsgemäße Verfahren hat sich insbesondere zur Bestimmung des Alterungszustandes von Leistungshalbleiter-Modulen geeignet herausgestellt. Die aktuelle mechanische Integrität des Moduls lässt sich über das Schwingungsverhalten des Substrats und daran angeordneter Bestandteile sehr sensitiv und reproduzierbar verfolgen. Es ergeben sich signifikante Messwerte, welche eine Extrapolation auf die noch verbleibende Restlebensdauer des Moduls ermöglichen.

Des Weiteren erfindungsgemäß ist ein System zur Bestimmung des Betriebszustandes eines Leistungshalbleiter-Moduls, wobei das System mindestens umfasst:
i) ein Leistungshalbleiter-Modul mindestens umfassend ein flächig ausgestaltetes piezoelektrisches Substrat mit mehreren metallischen Kontaktierungsstellen auf der Ober- und Unterseite des Substrats, wobei auf einer der metallischen Kontaktierungsstellen an der Oberseite ein Leistungshalbleiter angeordnet ist;
ii) ein auf der Oberseite des piezoelektrischen Substrats angeordneten Schwingungs-Sensor, wobei der Schwingungs-Sensor zur Bestimmung der Schwingungseigenschaften des piezoelektrischen Substrats eingerichtet ist;
iii) eine Spannungsversorgung, wobei die Spannungsversorgung eine metallische Kontaktierungsstelle an der Oberseite des piezoelektrischen Substrats und eine metallische Kontaktierungsstelle an der Unterseite des piezoelektrischen Substrats kontaktiert;
iv) eine Auswerteeinheit dazu eingerichtet einen Vergleich zwischen gemessenen Schwingungseigenschaften und Referenz-Schwingungseigenschaften durchzuführen;
v) eine Anzeige und/oder Speichereinheit.

Überraschenderweise wurde gefunden, dass sich über oben angegebenes System der Betriebszustand eines Leistungsmoduls verlässlich und reproduzierbar bestimmen lässt. Insbesondere können über das erfindungsgemäße System Alterungserscheinungen am Modul erkannt und eine Restbetriebsdauer des Moduls prognostiziert werden. Alternativ ist es auch möglich, dass über das System eine Wartung des Moduls oder ein Austausch initiiert oder angezeigt wird. Der Alterungszustand des Moduls wird indirekt über die Schwingungseigenschaften des Substrats bestimmt, welche sensitiv auf die Änderungen des mechanischen Aufbaus ist. Änderungen in der mechanischen Anbindung funktionaler Bestandteile, wie beispielsweise Leiterbahnen oder der Halbleiter-Chip, können zu Änderungen im Schwingungsverhalten des Substrats führen. Ein weiterer Vorteil des erfindungsgemäßen Systems bietet demnach die Möglichkeit einer Modul-Zustandsüberwachung, auf der eine Restlebensdauerbestimmung basieren kann. Es werden ungeplante Ausfälle des Moduls vermieden und eine vorausschauende Wartung ermöglicht. Des Weiteren ergibt sich eine kostengünstige Lösung für die Zustandsüberwachung von gesamten Leistungsmodulen in Umrichtern, welche auch für eine Lebensdauerprognose nutzbar ist. Zu den weiteren Vorteilen des erfindungsgemäßen Systems wird explizit auf die im Rahmen des erfindungsgemäßen Verfahrens diskutierten Vorteile Bezug genommen.

Das erfindungsgemäße System ist ein System zur Bestimmung des Betriebszustandes eines Leistungshalbleiter-Moduls. Typische Bauelemente eines Leistungshalbleiter-Moduls und mögliche Ausgestaltungen im Aufbau sind weiter oben im Rahmen des erfindungsgemäßen Verfahrens angegeben. Auf diese im Bereich des Verfahrens angegebenen Definitionen wird im Bereich des Systems vollumfänglich Bezug genommen. Dies betrifft insbesondere die im Punkt i) genannten Bauteile des Leistungshalbleiter-Moduls und die Eigenschaften und Ausgestaltungen des unter Punkt ii) genannten Schwingungs-Sensors.

Das System umfasst iii), eine Spannungsversorgung, wobei die Spannungsversorgung eine metallische Kontaktierungsstelle an der Oberseite des piezoelektrischen Substrats und eine metallische Kontaktierungsstelle an der Unterseite des piezoelektrischen Substrats kontaktiert. Die Spannungsversorgung ist insbesondere dazu eingerichtet über zumindest einen Teilvolumenbereich oder -oberflächenbereich des Substrats hinweg eine Spannung, bevorzugt eine Wechselspannung, zu induzieren. Dazu können an zwei unterschiedlichen Bereichen des Substrats elektrische Leiter angeordnet sein, welche mit einer gemeinsamen Spannungsversorgung verbunden sind. Es kann sich um weitere metallische Kontaktierungsstellen handeln, welche nicht im Aufbau üblicher Module vorhanden sind. Es ist aber auch möglich, dass Teilbereiche vorhandener elektrischer Strukturen des Moduls zur Erzeugung des elektrischen Feldes zur Änderung der piezoelektrischen Eigenschaften des Substrats genutzt werden.

Das System umfasst iv), eine Auswerteeinheit dazu eingerichtet einen Vergleich zwischen gemessenen Schwingungseigenschaften und Referenz-Schwingungseigenschaften durchzuführen. Die Auswerteeinheit kann mathematische Operationen durchführen und somit eine Relation zwischen aktuell gemessenen Werten und hinterlegten Standardwerten herbeiführen. Die Relation zwischen den Werten kann sich beispielsweise über eine Subtraktion oder eine Division der gemessenen mit den Referenzwerten ergeben. Es können aber auch komplexere mathematische Operationen, wie beispielsweise eine Mittelwertbildung oder eine Ableitung, über die Auswerteeinheit ausgeführt werden.

Das System umfasst v), eine Anzeige und/oder Speichereinheit. Die Anzeigeeinheit oder die Speichereinheit kann direkt mit dem Schwingungs-Sensor verbunden sein. Somit ist es beispielsweise möglich, dass über die Anzeigeeinheit der aktuell gemessene Wert des Schwingungs-Sensors stetig ausgegeben wird. Alternativ ist es auch möglich, dass die Anzeigeeinheit nur bei Bedarf die gemessenen Werte des Sensors oder das Ergebnis des Vergleiches anzeigt. Die Anzeige kann aber auch dazu eingerichtet sein, nur das Ergebnis des Vergleiches anzuzeigen, beispielsweise in Form einer Farbkodierung, welche den aktuellen Betriebszustand des Leistungsmoduls ausgibt. Diese Werte des Vergleichs oder davon abgeleitete Werte mathematischer Operationen können ebenfalls in der Speichereinheit abgelegt und beispielsweise über eine Schnittstelle ausgelesen werden. Die Anzeigeeinheit kann am Leistungsmodul angeordnet sein. Es ist aber auch möglich, dass die Anzeigeeinheit über ein Kommunikationsmittel mit der Auswerteeinheit oder der Speichereinheit verbunden und nicht direkt am Leistungsmodul angeordnet ist.

In einer bevorzugten Ausführungsform des Systems kann der Schwingungs-Sensor ein SAW- oder ein MEMS-Sensor sein. Aufgrund ihrer Robustheit und thermischen Stabilität haben sich Schwingungs-Sensoren mit oben genannten Grundaufbau oder aus oben genannten Klassen als besonders geeignet herausgestellt. Die Sensoren weisen eine hinreichende Sensitivität auch unter hohen Temperaturbelastungen sowie eine geringe Masse und Größe auf. Letzteres ist insbesondere günstig, um eine möglichst spezifische Aussage über die Eigenschaften und die mechanische Integrität des Moduls zu erhalten.

In einem bevorzugten Aspekt des Systems kann der Schwingungs-Sensor auf der Oberfläche des piezoelektrischen Substrats und im physikalischen Kontakt zur der metallischen Kontaktierungsstelle angeordnet sein, auf welcher der Leistungshalbleiter angeordnet ist. Zur Überwachung besonders sensibler und funktionaler Strukturen des Moduls hat sich eine Anordnung des Sensors in unmittelbarer Nähe zu dem Leistungshalbleiter tragenden elektrischen Anbindungsstelle als besonders geeignet herausgestellt. Mögliche Fehlerstellen können frühzeitig und mit einer hohen Genauigkeit erkannt werden. Dies kann die Beurteilung des Alterungsgrades des Moduls verbessern.

In einer bevorzugten Charakteristik des Systems kann die Auswerteeinheit einen elektronischen Filter umfassen, wobei der elektronische Filter dazu eingerichtet ist gemessene Frequenz- oder Amplitudenbereiche des Schwingungs-Sensors von der Auswertung auszuschließen. Neben einer Kompensation der aktuellen Betriebstemperatur des Moduls kann weiterhin die Robustheit des Systems durch Ausschluss bestimmter Schwingungswerte von der weiteren Beurteilung erhöht werden. Dieser Ausschluss bestimmter Schwingungswerte von der weiteren Evaluierung kann über die Verwendung eines elektronischen Filters in Form eines Frequenzfilters erfolgen, welcher beispielsweise in der Messelektronik des Sensors integriert, vorliegen kann. Es ist aber auch möglich, dass der elektronische Frequenzfilter digital im Rahmen der Auswerteroutine angewendet wird. Über die Filterfunktion können Fehlmessungen oder nicht signifikante Frequenz- oder Amplitudenbereiche von einem weiteren Vergleich mit Referenzwerten ausgeschlossen werden.

In einer bevorzugten Ausführungsform des Systems kann der auf der Oberseite des piezoelektrischen Substrats angeordnete Schwingungs-Sensor der Leistungshalbleiter sein, wobei der Leistungshalbleiter über die metallische Kontaktierungsstellen des Substrats und einen Bonddraht hinaus eine weitere elektrische Kontaktierung aufweist. Der Leistungshalbleiter kann ebenfalls piezoelektrische Eigenschaften aufweisen und ist somit prinzipiell als Sensor zu Detektion mechanischer Schwingungen geeignet. In diesem Fall kann auf einen separaten Schwingungs-Sensor verzichtet werden. Die Anbindung über ein Lot auf die metallischen Kontaktflächen auf dem Substrat führen zudem dazu, dass wichtige mechanische Anbindungen des Leistungshalbleiters direkt überwacht werden können. Es ergibt sich ein sensitives System, welches frühzeitig Alterungszustände des Moduls anzeigen kann. Zum Abgreifen der Schwingungseigenschaften kann die zusätzliche elektrische Anbindung des Halbleiter-Chips verwendet werden. Diese kann mit der Auswerteeinheit verbunden sein.

In einer weiterhin bevorzugten Ausführungsform des Systems kann der Schwingungs-Sensor ein SAW-Sensor sein, wobei der SAW-Sensor auf der Oberseite des Substrats angeordnet ist und eine nicht mit den metallischen Kontaktierungsstellen elektrisch leitend verbundene, elektrische Anbindung aufweist. Zur sensitiven Erfassung der Schwingungseigenschaften haben sich insbesondere SAW-Sensoren als geeignet erwiesen. Diese sind robust, sensitiv und können in einem weiten Temperaturbereich reproduzierbar Schwingungsparameter wie Amplituden und Frequenzen detektieren. Es können dabei ein oder mehrere Fingerstrukturen nach dem Prinzip eines SAW-Filters oberseitig auf den freiliegenden Rand der Keramik des Substrats aufgebracht sein und als Sensor zur Schwingungsaufnahme dienen. Die Keramik des DCB-Substrats fungiert dabei als piezoelektrisches Material, auf welches sonst bei SAW-Filtern die Fingerstruktur aufgebracht ist. Dabei kann die Fingerstruktur zur Leiterbahn hin isoliert sein und eine separate elektrische Zuleitung zur sensorischen Auswertung aufweisen.

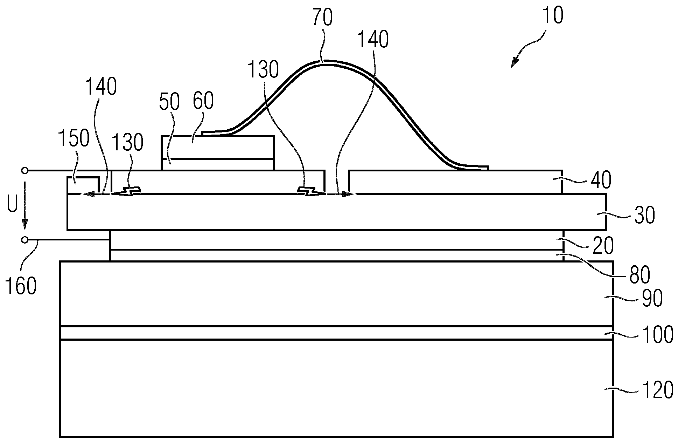

Beispiele und Ausführungsformen der vorliegenden Erfindung werden noch in exemplarischer Weise mit Bezug auf die Figur 1 beschrieben:
Figur 1 zeigt schematisch einen Aufbau eines Leistungs-Halbleitermoduls.

Die Figur 1 zeigt schematisch einen Aufbau eines Leistungs-Halbleitermoduls 10 umfassend den Aufbau eines Teils des erfindungsgemäßen Systems. Das Leistungshalbleiter-Modul umfasst die üblichen Bestandteile eines Leistungshalbleiter-Moduls. Zu diesen Bestandteilen des Leistungshalbleiter-Moduls 10 zählen untere Kupferanbindung 20 sowie Kupferleitungsbahnen 40, welche durch ein Substrat 30 getrennt sind. Das Substrat weist piezoelektrische Eigenschaften auf. Auf einer der Kupferleitungsbahnen 40 ist ein Lot 50 aufgebracht, welches den eigentlichen Leistungshalbleiter 60 auf der Kupferleitungsbahn 40 fixiert. Diese Seite der flächig ausgestalteten Keramik bildet die Oberseite der Keramik und des Moduls. Der Leistungshalbleiter 60 ist über einen Bonddraht 70 mit einer weiteren Kupferleitungsbahn 40 elektrisch verbunden. Diese funktionalen Bestandteile des Leistungs-Halbleitermoduls 10 sind über ein weiteres Lot 80 mit einer Bodenplatte 90 verbunden. Zur Wärmeabfuhr ist die Bodenplatte 90 mittels einer Wärmeleitpaste 100 an einem Kühlkörper 120 angeordnet. In einem fabrikneuen Zustand können über die elektrisch leitenden Verbindungen 160 eine Wechselspannung an das Substrat 30 mit piezoelektrischen Eigenschaften angelegt werden. Durch die Wechselspannung wird das Substrat 30 in Schwingungen versetzt, welche durch den Schwingungs-Sensor 140 detektiert werden können. Aufgrund der Tatsache, dass das Modul 10 neu ist, können Referenzwerte des Schwingungsverhaltens generiert werden. Im Laufe der Alterung können am Modul 10 Risse 130 auftreten. Diese Risse 140 interagieren als solche oder mit ihren Oberflächenwellen 140 mit den Schwingungen des Substrats 30. Insgesamt wird das Schwingungsverhalten des gesamten Aufbaus geändert und werden abweichende Schwingungs-Werte des Substrats 30 erhalten. Derart kann eine Alterung des Leistungshalbleiter-Moduls 10 festgestellt und quantifiziert werden. In dieser Figur sind die weiteren Bestandteile des erfindungsgemäßen Systems, wie beispielsweise Auswerteeinheit und Anzeigeeinheit, nicht dargestellt. Der Sensor 150 kann beispielsweise ein MEMS oder ein SAW-Sensor sein. Es ist aber auch möglich, dass der Leistungshalbleiter 60 selbst als Sensor genutzt wird, da dieser ebenfalls piezoelektrische Eigenschaften aufweist. In diesem Fall weist der Leistungshalbleiter 60 eine eigene elektrisch leitende Anbindung 160 (nicht dargestellt auf). Als Funktion der elektrisch leitenden Anbindungen 160 des Substrats 30, lassen sich unterschiedliche Teil- oder Oberflächenbereiche des Substrats 30 zu Schwingungen anregen. In dieser Ausgestaltung ist angegeben, dass die elektrisch leitenden Anbindungen 160 des Substrats 30 über die untere Kupferanbindung 20 und die Kupferleitungsbahnen 40 auf der Oberseite des Substrats 30 erfolgen.

### Bezugszeichenliste

- 10: Leistungshalbleiter-Modul
- 20: untere Kupferanbindung
- 30: Substrat
- 40: Kupferleitungsbahnen
- 50: Lot
- 60: Leistungshalbleiter
- 70: Bonddraht
- 80: unteres Lot
- 90: Bodenplatte
- 100: Wärmeleitpaste
- 120: Kühlkörper
- 130: Riss
- 140: Oberflächenwelle
- 150: Schwingungs-Sensor
- 160: elektrisch leitende Anbindung

## Patentansprüche

1. Verfahren zur Überprüfung des Betriebszustandes eines Leistungshalbleiter-Moduls (10) mindestens umfassend ein flächig ausgestaltetes piezoelektrisches Substrat (30) mit mehreren metallischen Kontaktierungsstellen (20, 40) auf der Ober- und Unterseite des Substrats (30), wobei auf einer der metallischen Kontaktierungsstellen (40) an der Oberseite ein Leistungshalbleiter (60) und auf dem piezoelektrischen Substrat (30) ein Schwingungs-Sensor (150) angeordnet ist, wobei das Verfahren die Schritte umfasst:
a) Aussenden mechanischer Schwingungen durch elektrische Anregung zumindest eines Teilbereiches des piezoelektrischen Substrats (30);
b) Ermitteln der Schwingungs-Werte der Schwingungen des Substrats (30) durch den Schwingungs-Sensor (150);
c) Vergleich der im Verfahrensschritt b) gemessenen Schwingungs-Werte mit einem oder mehreren Schwingungs-Referenzwerten, wobei die Schwingungs-Referenzwerte an einem Leistungshalbleiter-Modul (10) mit bekannten Betriebszustand erhoben wurden;
d) Ausgeben einer Mitteilung und/oder Ablegen des im Verfahrensschritt c) ermittelten Vergleichsergebnisses in einem elektronischen Speicher.

2. Verfahren nach Anspruch 1, wobei die elektrische Anregung des piezoelektrischen Substrats (30) im Verfahrensschritt a) durch Anlegen einer Spannung zwischen einer metallischen Kontaktierungsstelle (40) auf der Oberseite des Substrats (30) und auf einer dieser Seite entgegengesetzten Unterseite des Substrats (30) erfolgt.

3. Verfahren nach Anspruch 2, wobei die elektrische Anregung des piezoelektrischen Substrats (30) im Verfahrensschritt a) durch Anlegen einer Spannung an mindestes der metallischen Kontaktierungsstelle (40) erfolgt, auf welcher der Leistungshalbleiter (60) angeordnet ist.

4. Verfahren nach einem der vorhergehenden Ansprüche, wobei die Schwingungs-Werte im Verfahrensschritt b) durch einen MEMS- (mikro-elektro-mechanisches System) oder durch einen SAW- (Surface acoustic wave) Sensor gemessen werden.

5. Verfahren nach einem der vorhergehenden Ansprüche, wobei der Schwingungs-Sensor (150) mindestens die Frequenz und/oder Amplitude von Schwingungen des Substrats (30) erfasst.

6. Verfahren nach einem der vorhergehenden Ansprüche, wobei das piezoelektrische Substrat (30) aus AIN und die metallischen Kontaktierungsstellen (40) aus Kupfer bestehen.

7. Verfahren nach einem der vorhergehenden Ansprüche, wobei der Vergleich im Verfahrensschritt c) unter Berücksichtigung der aktuellen Temperatur des Leistungshalbleiter-Moduls (10) erfolgt.

8. Verfahren nach einem der vorhergehenden Ansprüche, wobei das Ermitteln der Schwingungs-Werte im Verfahrensschritt b) unter Verwendung eines elektronischen Frequenzfilters erfolgt.

9. Verwendung eines Verfahrens nach einem der vorhergehenden Ansprüche zur Bestimmung der mechanischen Integrität eines Leistungshalbleiter-Moduls (10).

10. System zur Bestimmung des Betriebszustandes eines Leistungshalbleiter-Moduls (10), **dadurch gekennzeichnet, dass** das System mindestens umfasst:
i) ein Leistungshalbleiter-Modul (10) mindestens umfassend ein flächig ausgestaltetes piezoelektrisches Substrat (30) mit mehreren metallischen Kontaktierungsstellen (20, 40) auf der Ober- und Unterseite des Substrats (30), wobei auf einer der metallischen Kontaktierungsstellen (40) an der Oberseite ein Leistungshalbleiter (60) angeordnet ist;
ii) ein auf der Oberseite des piezoelektrischen Substrats (30) angeordneten Schwingungs-Sensor (150), wobei der Schwingungs-Sensor (150) zur Bestimmung der Schwingungseigenschaften des piezoelektrischen Substrats (30) eingerichtet ist;
iii) eine Spannungsversorgung, wobei die Spannungsversorgung eine metallische Kontaktierungsstelle (40) an der Oberseite des piezoelektrischen Substrats (30) und eine metallische Kontaktierungsstelle (20) an der Unterseite des piezoelektrischen Substrats (30) kontaktiert;
iv) eine Auswerteeinheit dazu eingerichtet einen Vergleich zwischen gemessenen Schwingungseigenschaften und Referenz-Schwingungseigenschaften durchzuführen;
v) eine Anzeige und/oder Speichereinheit.

11. System nach Anspruch 10, wobei der Schwingungs-Sensor (150) ein SAW- oder ein MEMS-Sensor ist.

12. System nach Anspruch 10 oder 11, wobei der Schwingungs-Sensor (150) auf der Oberfläche des piezoelektrischen Substrats (30) und im physikalischen Kontakt zur der metallischen Kontaktierungsstelle (40) angeordnet ist, auf welcher der Leistungshalbleiter (60) angeordnet ist.

13. System nach einem der Ansprüche 10 bis 12, wobei die Auswerteeinheit einen elektronischen Filter umfasst, wobei der elektronische Filter dazu eingerichtet ist gemessene Frequenz- oder Amplitudenbereiche des Schwingungs-Sensors (150) von der Auswertung auszuschließen.

14. System nach einem der Ansprüche 10 bis 13, wobei der auf der Oberseite des piezoelektrischen Substrats (30) angeordnete Schwingungs-Sensor (150) der Leistungshalbleiter (60) ist, wobei der Leistungshalbleiter (60) über die metallische Kontaktierungsstellen des Substrats (30) und einen Bonddraht (70) hinaus eine weitere elektrische Kontaktierung aufweist.

15. System nach Anspruch 11, wobei der Schwingungs-Sensor (150) ein SAW-Sensor ist, wobei der SAW-Sensor auf der Oberseite des Substrats (30) angeordnet ist und eine nicht mit den metallischen Kontaktierungsstellen (20, 40) elektrisch leitend verbundene, elektrische Anbindung (160) aufweist.
